# EUROPÄISCHE PATENTANMELDUNG

(11) **EP 3 131 202 A1**
(43) Veröffentlichungstag der Anmeldung: **15.02.2017**
(21) Anmeldenummer: 15180564.5
(22) Anmeldetag: 11.08.2015
(51) Int. Cl.: H03H 17/02, G05B 19/18

(54) **FILTERUMSCHALTVERFAHREN FÜR EINE MASCHINENSTEUERUNG**

(71) Anmelder: Siemens Aktiengesellschaft, 80333 München (DE)
(72) Erfinder: Geissdörfer, Klaus, 91056 Erlangen (DE); Hamm, Carsten, 91058 Erlangen (DE); Reichel, Theo, 91301 Forchheim (DE); Schäfers, Elmar, 90763 Fürth (DE); Schür, Torsten, 91058 Erlangen (DE)

(57) **Zusammenfassung**

Die Erfindung betrifft ein Verfahren (100) zum Umschalten zwischen Sollwertfiltern (26, 28) eines Antriebsmittels (52) einer Maschinenachse (10, 12) während des Betriebs. Darin wird ein Eingangssignal (20) an das erste und zweite Sollwertfilter (26, 28) zur Erzeugung eines ersten und zweiten Ausgangssignals (23, 33) angelegt. Anschließend wird zwischen dem ersten und zweiten Ausgangssignal (23, 33) eine Abweichung ermittelt. Wenn die Abweichung einen Schwellenwert unterschreitet, wird das erste Sollwertfilter (26) vom Antriebsmittel (52) getrennt und im Wesentlichen gleichzeitig das zweite Sollwertfilter (28) mit dem Antriebsmittel (52) verbunden. Dabei weisen die Sollwertfilter (26, 28) unterschiedliche Laufzeiten (19) auf.

## Beschreibung

Die Erfindung betrifft ein Verfahren zum Umschalten zwischen Sollwertfiltern einer Maschinensteuerung für ein Antriebsmittel einer Maschine während des Betriebs. Die Erfindung betrifft auch ein Programm, eine Steuereinheit einer Maschine und eine solche Maschine.

Aus EP 0 477 412 A1 ist ein Filterungsverfahren für eine Maschinensteuerung bekannt, in der digitale Signale mit Filtern geglättet werden. Die Filter, zwischen denen umgeschaltet wird, weisen unterschiedliche Filterlängen auf. Dabei wird die Wegdifferenz zwischen dem durch die Sollwerte vorgegebenen Weges und dem infolge des Filters verringerten zurückgelegten Weges ermittelt. Beim Umschalten wird durch rechnerische Modifikation einer Feedback-Schleife an den Signaleingang die Wegabweichung entlang der Bewegungsrichtung minimiert.

EP 0 135 024 B1 offenbart eine Übertragungsanordnung für Audiosignale, die zwei Signalzweige aufweist, wobei in jedem Signalzweig ein digitales Übertragungsglied angeordnet ist. Jedes Übertragungsglied weist zu seiner Konfiguration einen Koeffizientensatz auf. Zwischen den Signalzweigen ist ein Diskriminator angebracht, der mit den Ausgangssignalen beider Übertragungsglieder versorgt wird. Es wird das mathematische Vorzeichen einer Differenz zwischen den Ausgangssignalen beider Übertragungsglieder erfasst und, bei einem Vorzeichenwechsel, ein Umschaltsignal für die Übertragungsglieder gegeben.

Nachteilig an den bekannten Möglichkeiten zum Umschalten zwischen unterschiedlichen Filtern ist, dass dabei eine erhebliche Gefahr eines stufenartigen, also unstetigen Übergangs bei den Sollwerten der Ausgangssignale besteht, mit denen die Antriebe einer Maschine angesteuert werden. Ein hinreichend glatter Übergang von einem Filter zum anderen, wie er zum Beispiel für Präzisionsanwendungen notwendig ist, erfordert typischerweise einen Stillstand der jeweiligen Maschinenachse. Ferner erfordern Umschaltverfahren, bei denen eine reduzierte Gefahr eines stufenartigen Übergangs von Ausgangssignalen besteht, hohe Rechenleistung. Es besteht Bedarf an einem Filterumschaltverfahren, das die Nachteile aus dem Stand der Technik überwindet, das zuverlässig ein glattes Umschalten zwischen verschiedenen Filtern während einer Maschinenbewegung ermöglicht, und mit geringen Anforderungen in puncto Rechenleistung umsetzbar ist.

Die Aufgabenstellung wird durch das erfindungsgemäße Verfahren gelöst. Das erfindungsgemäße Filterumschaltverfahren wird in einer Maschinensteuerung während des Betriebs eines Antriebsmittels durchgeführt, das zu einer ersten Maschinenachse gehört. Die Maschinensteuerung weist ein erstes und ein zweites Sollwertfilter für die Maschinenachse auf, zwischen denen umzuschalten ist. In einem ersten Verfahrensschritt wird ein Eingangssignal, das von einer weiteren Komponente der Maschinensteuerung über eine Eingangseinheit zur Verfügung gestellt wird, an das erste Sollwertfilter angelegt. Das Eingangssignal wird vom ersten Sollwertfilter verarbeitet, so dass ein erstes Ausgangssignal erzeugt wird, das während des Betriebs der Maschine an das Antriebsmittel weitergeleitet wird.

In einem weiteren Verfahrensschritt wird das Eingangssignal dupliziert und gleichzeitig an das zweite Sollwertfilter angelegt. Das zweite Sollwertfilter erzeugt anhand des Eingangssignals ein zweites Ausgangssignal. In einem anschließenden Verfahrensschritt werden das erste und zweite Ausgangssignal an eine Subtraktionseinheit weitergeleitet, die eine Differenz zwischen dem ersten und zweiten Ausgangssignal bildet. Die gebildete Differenz ist die Abweichung des ersten und zweiten Ausgangssignals untereinander, die in einem weiteren Verfahrensschritt in einem Komparator weiter ausgewertet wird.

Wenn die Abweichung zwischen dem ersten und zweiten Sollwertfilter einen einstellbaren Schwellenwert unterschreitet, liegt bei einem Umschalten zwischen den Sollwertfiltern eine minimierte Unstetigkeit vor, so dass die erste Maschinenachse nur minimal von ihrer vorgesehenen Trajektorie abweicht. Der Schwellenwert definiert das Maß an Unstetigkeit, das bei einem Filterumschalten im vorliegenden Anwendungsfall hinnehmbar ist. Wenn die von der Subtraktionseinheit ermittelte Abweichung den Schwellenwert unterschreitet, wird unmittelbar das erste Sollwertfilter vom Antriebsmittel getrennt und im Wesentlichen gleichzeitig das zweite Sollwertfilter mit dem Antriebsmittel verbunden. Das unmittelbare Trennen und Verbinden des ersten bzw. zweiten Sollwertfilters erfolgt dabei mit der maximal erzielbaren Betätigungsgeschwindigkeit, also unter Auslassen und Umgehen vermeidbarer Zeitverluste.

Im erfindungsgemäßen Verfahren weisen das erste und das zweite Sollwertfilter unterschiedliche Laufzeiten auf. Die Laufzeit ist bei heute typischen Sollwertfiltern ein Maß für die erzielbare Dynamik und Bewegungspräzision bei der Betätigung des Antriebsmittels. Ein Sollwertfilter mit einer niedrigen Laufzeit gewährleistet ein hohes Maß an Dynamik, also hohe Rucke und Beschleunigungen. Ein Sollwertfilter hingegen, der für hohe Bewegungspräzision ausgelegt ist, weist typischerweise eine hohe Laufzeit auf. Der Erfindung liegt die überraschende Erkenntnis zugrunde, dass das beschriebene Umschaltverfahren auch bei Sollwertfiltern mit unterschiedlichen Laufzeiten zu einem unerwartet glatten Umschalten zwischen den Sollwertfiltern führt.

Das erfindungsgemäße Verfahren erlaubt es, ein Antriebsmittel für die erste Maschinenachse je nach Einsatzerfordernis zwischen unterschiedlichen Betriebsmodi umzuschalten. Typischerweise erfordert eine Nebenzeitbewegung, in der die Maschine mit hoher Dynamik verfährt, einen anderen Sollwertfilter als beispielweise bei einer spanenden Bearbeitung eines Werkstücks. Das erfindungsgemäße Verfahren erfordert lediglich, dass die beiden Sollwertfilter in puncto Ausgangssignal parallel laufen. Dabei handelt es sich um eine Bedingung, die schnell und in einfacher Weise durch Subtraktion der Ausgangssignale erfassbar ist. Ferner ist das erfindungsgemäße Verfahren stetig, d.h. dass das Filterumschalten nur bei minimierten Rucken und Beschleunigungen erfolgt. Dadurch werden übermäßiger Verschleiß und Beanspruchungen des Antriebsmittels vermieden. Das erfindungsgemäße Verfahren erlaubt ein Umschalten von Sollwertfiltern mit beliebigen Laufzeiten und weist ein breites Einsatzspektrum auf.

In einer bevorzugten Ausführungsform der Erfindung erfolgen das Trennen des ersten Sollwertfilters vom Antriebsmittel und das Verbinden des zweiten Sollwertfilters mit dem Antriebsmittel während einer Bewegung entlang der ersten Maschinenachse. Die Voraussetzung für das Trennen und Verbinden besteht darin, dass die Ausgangssignale an den Sollwertfiltern zumindest zeitweilig parallel laufen. Ein Umschalten der Sollwertfilter während einer Bewegung entlang der ersten Maschinenachse vermeidet Stillstandzeiten der Maschine und erhöht deren Effizienz. Infolgedessen erlaubt es das erfindungsgemäße Verfahren, die technischen Möglichkeiten der Maschine weiter auszuschöpfen.

Weiter bevorzugt kann im erfindungsgemäßen Verfahren in der Maschinensteuerung mindestens ein Verzögerungsglied angeordnet, das den Durchlauf des Eingangssignals oder des Ausgangssignals durch den jeweiligen Filterstrang abbremst. Das Verzögerungsglied verhält sich zum Inhalt des Eingangssignal bzw. Ausgangssignal neutral und weist als einzigen Parameter seine Totzeit auf. Das Verzögerungsglied ist vorzugsweise softwaremäßig ausgebildet, und damit durch die Maschinensteuerung einstellbar, so dass die Totzeit des Verzögerungsglieds angepasst werden kann. Die Summe aus der Totzeit des Verzögerungsglieds und der Laufzeit des zugehörigen Sollwertfilters bilden die Gesamt-Laufzeit eines Filterstrangs. Das Verzögerungsglied erlaubt es, die Gesamt-Laufzeit des ersten Filterstrangs mit dem ersten Sollwertfilter an die Gesamt-Laufzeit des zweiten Filterstrangs anzupassen. Dadurch wird gewährleistet, dass bei der Ermittlung der Abweichung der Ausgangssignale untereinander stets miteinander korrespondierende Abschnitte der Ausgangssignale miteinander verglichen werden. Beispielweise werden stets der Signalanfang des ersten Ausgangssignals und der Signalanfang des zweiten Ausgangssignals voneinander subtrahiert. Dadurch wird ein für das Umschalten der Sollwertfilter geeigneter Zustand schnell und zuverlässig erkannt. Dadurch können auch nur kurzfristig vorliegende geeignete Zustände für ein Filterumschalten genutzt werden. Das erfindungsgemäße Verfahren weist damit eine erhöhte Leistungsfähigkeit auf.

In einer besonders bevorzugten Ausführungsform des erfindungsgemäßen Verfahrens entspricht die Totzeit des mindestens einen Verzögerungsglieds einem nicht-ganzzahligen Vielfachen einer Taktdauer des Eingangssignals. Infolgedessen kann die Gesamt-Totzeit eines Filterstrangs um ein beliebiges Maß erhöht werden. Das erfindungsgemäße Verfahren kann somit in einfacher Weise an eine Vielzahl von Anwendungsfällen angepasst werden.

Weiter bevorzugt kann die Länge der Totzeit des mindestens einen Verzögerungsglieds der Differenz der Totzeiten des ersten und zweiten Sollwertfilters entsprechen. Eine derartige Totzeit erlaubt es, die Gesamt-Laufzeit eines Filterstrangs lediglich soweit zu erhöhen, bis die Gesamt-Laufzeit eines parallelen Filterstrangs erreicht ist. Infolgedessen bleiben die Gesamt-Laufzeiten aller Filterstränge im erfindungsgemäßen Verfahren minimal. Folglich erfordert das beanspruchte Verfahren einen Signalpuffer mit verringerter Kapazität. Das Filterumschaltverfahren kann in einfacher Weise auch in Maschinensteuerungen mit wenig Rechenkapazität nachgerüstet werden.

Ferner kann das Eingangssignal im beanspruchten Verfahren einen Positionssollwert, einen Geschwindigkeitssollwert, einen Beschleunigungssollwert und/oder einen Rucksollwert für das Antriebsmittel umfassen. Beim Ermitteln der Abweichung der Ausgangssignale können damit wahlweise Differenzen in puncto angestrebter Position, Geschwindigkeit, Beschleunigung, Ruck, oder einer Kombination von mehreren dieser Größen berechnet werden. Je nach Anwendungsfall kann eine bestimmte dieser Größen einen Zustand, in dem ein glattes Filterumschalten möglich ist, am zweckmäßigsten charakterisieren. Beispielsweise liefert der Geschwindigkeitssollwert für ein Filterumschalten von einer Nebenzeitbewegung zu einer präzisen Bearbeitungsbewegung eine besonders präzise Information darüber, ob ein dazu geeigneter Zustand vorliegt. Ferner kann durch eine Kombination von mehreren der genannten Sollwerte ein beliebig angepasstes Kriterium gewählt werden, das für den jeweiligen Anwendungsfall am aussagekräftigsten ist.

In einer besonders bevorzugten Ausführungsform der Erfindung wird beim Ermitteln der Abweichung der Ausgangssignale lediglich die Abweichung der Positionssollwerte in den Ausgangssignalen ermittelt. Positionssollwerte liegen in der Maschinensteuerung unmittelbar vor. Geschwindigkeits-, Beschleunigungs- und Rucksollwerte sind abgeleitete Größen, die durch zusätzliche Komponenten in der Maschinensteuerung zu ermitteln sind. Positionssollwerte sind in einer Vielzahl von Maschinensteuerungen die Sollwerte, die unmittelbar von einer übergeordneten Steuerinstanz auf Basis eines Teileprogramms und/oder einer Nebenzeitsteuerung bereitgestellt werden. Überraschenderweise gewährleistet die Verwendung des Positionssollwertes alleine bereits einen für viele Anwendungen hinreichend glatten Übergang zwischen den Sollwertfiltern. Damit ist das erfindungsgemäße Verfahren auch in Maschinensteuerungen mit geringer Rechenkapazität in effizienter Weise umsetzbar. Das beanspruchte Verfahren ist dazu geeignet, als Teil eines Nachrüstpakets implementiert zu werden.

Die einzelnen Schritte des erfindungsgemäßen Verfahrens können in einer weiteren Ausführungsform auch für eine zweite Maschinenachse durchgeführt werden. Für die zweite Maschinenachse werden ebenfalls die Ausgangssignale an unterschiedlichen Sollwertfiltern auf eine Abweichung geprüft und ein Umschalten zwischen den Sollwertfiltern ermöglicht, wenn die Abweichung einen Schwellenwert unterschreitet. Das Trennen der ersten Sollwertfilter der ersten und zweiten Maschinenachse und das entsprechende Verbinden der zweiten Sollwertfilter mit den Antriebsmitteln der ersten und zweiten Maschinenachse wird durchgeführt, wenn bei beiden Maschinenachsen beide Abweichungen ihren jeweiligen Schwellenwert gleichzeitig unterschreiten. Dadurch erfolgt das Umschalten zwischen den ersten und zweiten Sollwertfiltern in beiden Maschinenachsen im Wesentlichen gleichzeitig.

Ein gleichzeitiges Umschalten der Sollwertfilter an zwei Maschinenachsen erlaubt es, den Umschaltvorgang bei einer Bewegung der Maschine durchzuführen, die durch die Überlagerung der zwei Maschinenachsen hervorgerufen wird, beispielsweise eine Diagonalbewegung eines Werkzeugs. Bei einem zeitlich versetzten Filterumschalten der ersten und zweiten Maschinenachse besteht die Gefahr, dass zwischen den beiden Umschaltvorgängen eine Positionsabweichung der Maschine eintritt. Dies ist, beispielsweise beim Umschalten von einer Nebenzeitbewegung zu einer Bearbeitungsbewegung, der erzielbaren Fertigungspräzision abträglich. Ferner können sich derartige Positionsabweichungen addieren und die erzielbare Fertigungspräzision bei einer langen Laufzeit eines Fertigungsprogramms erheblich reduzieren. Das erfindungsgemäße Verfahren gewährleistet ein im Wesentlichen gleichzeitiges Filterumschalten in mehreren Maschinenachsen und wirkt damit der Gefahr eines Präzisionsverlusts auch bei langen Fertigungsprogrammen entgegen. Dadurch wird die erzielbare Betätigungsgenauigkeit der Maschine erhöht und deren technisches Potential weiter ausgeschöpft. Das erfindungsgemäße Verfahren kann in gleicher Weise auch auf drei oder mehr Maschinenachsen übertragen werden.

Besonders bevorzugt wird im erfindungsgemäßen Verfahren in der zweiten Maschinenachse die einstellbare Totzeit der Verzögerungsglieder durch Ergänzen derartig angepasst, dass die Ausgabe der Ausgangssignale beider Maschinenachsen im Wesentlichen gleichzeitig erfolgt. Dadurch werden in den Subtraktionseinheiten und den Komparatoren bei beiden Maschinenachsen zueinander korrespondierende Ausgangssignale gleichzeitig verglichen. Dadurch erlaubt es das erfindungsgemäße Verfahren, mit minimaler Verzögerung das Vorliegen eines Zustands zu erkennen, der für ein glattes Filterumschalten geeignet ist. Folglich können auch nur kurzfristig vorliegende geeignete Zustände genutzt werden, so dass die Flexibilität einer Maschinensteuerung beim Filterumschalten gesteigert wird.

In einer weiteren bevorzugten Ausführungsform der Erfindung ist mindestens eines der Sollwertfilter als Mittelwertbilder ausgebildet. Mittelwertbilder sind einfache und dadurch schnelle Sollwertfilter, die dazu geeignet sind, zuverlässig ein abruptes, stufenartiges Eingangssignal zu einem stetigen Ausgangssignal zu glätten. Mittelwertbilder sind auch gegen stark ansteigende oder abfallende Eingangssignale robust und erhöhen die Komplexität eines Regelungssystems nur in minimalem Umfang. Ferner weisen Mittelwertbilder eine lineare Phase auf, und die Gruppenlaufzeit ist frequenzunabhängig. Durch die Verwendung eines Mittelwertbilders als Sollwertfilter wird die Effizienz des erfindungsgemäßen Verfahrens weiter gesteigert.

Weiter bevorzugt kann im erfindungsgemäßen Verfahren mittels einer Look-Ahead-Funktion eine künftig auszuführende Bewegung entlang mindestens einer Maschinenachse vorausberechnet bzw. antizipiert werden. Im Einzelnen wird dabei das dazu erforderliche Eingangssignal erkannt und ausgewertet. Die Auswertung des antizipierten Eingangssignals erfolgt dahingehend, wann damit zu rechnen ist, dass ein zum Filterumschalten geeigneter Zustand der Maschinensteuerung vorliegt. Der geeignete Zustand zum Filterumschalten liegt vor, wenn die ermittelte Abweichung der Ausgangssignale den Schwellenwert unterschreitet. Dieser Zustand ist dadurch antizipierbar, wenn über einen Mindestzeitraum eine Bewegung der Maschinenachse mit im Wesentlichen konstanter Geschwindigkeit durch das Eingangssignal hervorgerufen wird.

Folglich ermöglicht es das erfindungsgemäße Verfahren, beim Ablauf eines Fertigungsprogramms den optimalen Zeitpunkt zum Filterumschalten zu identifizieren. Beispielsweise wird bei einem Umschalten von einer Bearbeitungsbewegung zu einer Nebenzeitbewegung ein möglichst frühes Filterumschalten angestrebt. Ferner wird bei einem Umschalten von einer Nebenzeitbewegung auf eine Bearbeitungsbewegung ein möglichst spätes Filterumschalten angestrebt. Das erfindungsgemäße Verfahren erlaubt es damit, bei der Planung eines Fertigungsprogramms das Optimierungspotential in puncto Filterumschalten exakt abzubilden. Dadurch wird die Optimierung eines Fertigungsprogramms mit Bearbeitungsbewegungen und Nebenzeitbewegungen erleichtert.

Die zugrundeliegende Aufgabenstellung wird auch durch das erfindungsgemäße Programm gelöst. Das beanspruchte Programm ist dazu ausgebildet, in einer Steuereinheit einer Maschinensteuerung gespeichert und ausgeführt zu werden. Dabei ist das Programm dazu geeignet, Befehle an mindestens ein Antriebsmittel einer zugehörigen Maschine auszugeben. Das beanspruchte Programm ist ferner dazu ausgebildet, mindestens eine Ausführungsform des erfindungsgemäßen Verfahrens auszuführen und auf der Maschine umzusetzen. Das erfindungsgemäße Programm erlaubt es, das technische Potential einer Maschine stärker auszunutzen, einen Fertigungsvorgang zu beschleunigen und erfordert geringe Rechenleistung. Das Programm kann dadurch auf eine bestehende Maschinensteuerung im Zuge einer einfachen und kosteneffizienten Nachrüstung aufgespielt werden.

Die Aufgabenstellung wird ferner durch eine Steuereinheit gelöst, die einen Speicher und eine Recheneinheit aufweist. Der Speicher und die Recheneinheit sind dazu geeignet, das erfindungsgemäße Programm zu speichern und auszuführen. Gleichermaßen wird die der Erfindung zugrundeliegende Aufgabe durch eine Maschine gelöst, die ein Werkzeug und ein Antriebsmittel aufweist und mit einer erfindungsgemäßen Steuereinheit ausgestattet ist.

Die vorliegende Erfindung wird im Folgenden anhand von Figuren von einzelnen Ausführungsformen näher erläutert. Die einzelnen Merkmale der dargestellten Ausführungsformen können im Rahmen des fachmännischen Wissens auch untereinander kombiniert werden. Es zeigt im Einzelnen:
- FIG 1: schematisch einen Aufbau eines Regelungssystems zur Durchführung einer ersten Ausführungsform des beanspruchten Verfahrens;
- FIG 2: schematisch einen Aufbau eines Regelungssystems zur Durchführung einer zweiten Ausführungsform des beanspruchten Verfahrens;
- FIG 3: schematisch einen Aufbau eines Regelungssystems zur Durchführung einer dritten Ausführungsform des beanspruchten Verfahrens;
- FIG 4: eine Ablaufdiagramm gemäß der dritten Ausführungsform des beanspruchten Verfahrens;
- FIG 5: ein Ablaufdiagramm einer vierten Ausführungsform des beanspruchten Verfahrens.

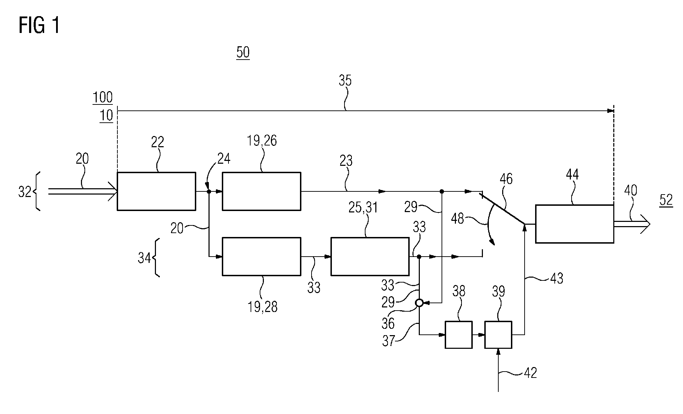

FIG 1 zeigt ein Regelungssystem, das zur Durchführung einer ersten Ausführungsform des erfindungsgemäßen Verfahrens 100 in einer Maschinensteuerung 50 ausgelegt ist. Darin wird für eine erste Maschinenachse 10 ein Eingangssignal 20 zur Verfügung gestellt, dass an einer Eingangseinheit 22 ins das beanspruchte Verfahren 100 eintritt. Ausgehend von der Eingangseinheit 22 erfolgt ein Signaldurchlauf 35 in Richtung einer Ausgangseinheit 44, die ein Ausgangssignal 40 an ein nicht näher dargestelltes Antriebsmittel 52 ausgibt. Ausgehend von der Eingangseinheit 22 erfolgt eine Duplikation 24 des Eingangssignals 20, so dass ein erstes und ein zweites Sollwertfilter 26, 28 mit dem identischen Eingangssignal 20 gespeist werden. Dabei ist das erste Sollwertfilter 26 in einem ersten Filterstrang 32 angeordnet und das zweite Sollwertfilter 28 in einem parallelen zweiten Filterstrang 34. Beide Sollwertfilter 26, 28 weisen jeweils eine unterschiedliche Laufzeit 19 auf. Das erste Sollwertfilter 26 erzeugt aus dem Eingangssignal 20 ein erstes Ausgangssignal 23. Parallel dazu erzeugt das zweite Sollwertfilter 28 aus dem Eingangssignal 20 ein zweites Ausgangssignal 33, das an ein Verzögerungsglied 31 weitergeleitet wird. Das Verzögerungsglied 31 weist eine einstellbare Totzeit 25 auf und verhält sich zum zweiten Ausgangssignal 33 neutral. Das zweite Ausgangssignal 33 wird über einen Signalabzweig 29 an eine Subtraktionseinheit 36 weitergeleitet. Das erste Ausgangssignal 23 vom ersten Sollwertfilter 26 wird auch über einen Signalabzweig 29 an die Subtraktionseinheit weitergeleitet. Die Subtraktionseinheit 36 bildet die Differenz 37 zwischen dem ersten und zweiten Ausgangssignal 23, 33 und leitet die Differenz 37 an einen Komparator 38 weiter. Der Komparator 38 ist dazu ausgebildet, zu erkennen, ob die Differenz 37 einen einstellbaren Schwellenwert unterschreitet. Ein Vorliegen einer Differenz 37, die niedriger ist als der einstellbare Schwellenwert, wird an eine Befehlseinheit 39 weitergeleitet. Die Befehlseinheit 39 ist zum Empfangen eines Umschaltbefehls 42 von einer übergeordneten Steuerung ausgebildet und gibt einen Umschaltbefehl 43 aus, wenn durch den Komparator 38 gleichzeitig eine Differenz 37 der Ausgangssignale 23, 33 unterhalb des Schwellenwerts gemeldet wird. Durch den Umschaltbefehl 43 wird ein Umschaltvorgang 48 eines Schaltmittels 46 hervorgerufen. Das Schaltmittel 46 bestimmt durch seinen Schaltzustand, welches der beiden Sollwertfilter 26, 28 mit der Ausgabeeinheit 44 verbunden ist.

In der Ausführungsform gemäß FIG 1 entspricht die Summe der Laufzeit 19 und der Totzeit 25 des zweiten Sollwertfilters 28 bzw. des Verzögerungsglieds 31 im Wesentlichen der Laufzeit 19 des ersten Sollwertfilters 26. Infolgedessen liegen an der Subtraktionseinheit 36 stets korrespondierende, also synchrone Ausgangssignale 23, 33 an. Dadurch werden Zustände, in denen ein Umschaltvorgang 48 glatt durchführbar ist, mit minimierter Verzögerung erkannt. Dadurch können zum Umschalten der Sollwertfilter 26, 28 auch Zustände genutzt werden, die nur kurzfristig zum glatten Filterumschalten geeignet sind.

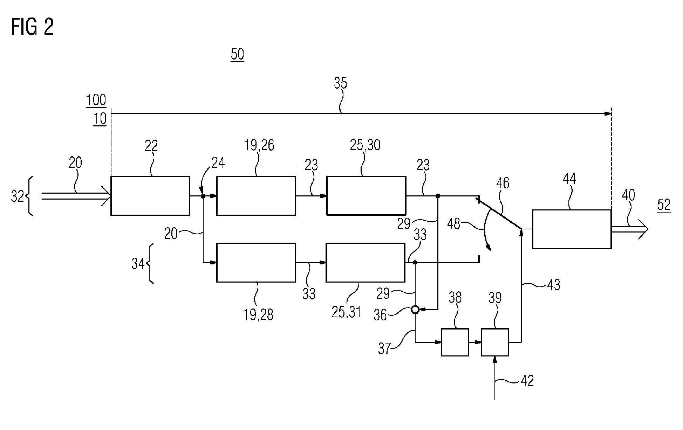

FIG 2 zeigt ein Regelungssystem, das zur Durchführung einer zweiten Ausführungsform des erfindungsgemäßen Verfahrens 100 in einer Maschinensteuerung 50 ausgelegt ist. Darin wird für eine erste Maschinenachse 10 ein Eingangssignal 20 zur Verfügung gestellt, dass an einer Eingangseinheit 22 ins das beanspruchte Verfahren 100 eintritt. Ausgehend von der Eingangseinheit 22 erfolgt ein Signaldurchlauf 35 in Richtung einer Ausgangseinheit 44, die ein Ausgangssignal 40 an ein nicht näher dargestelltes Antriebsmittel 52 ausgibt. Ausgehend von der Eingangseinheit 22 erfolgt eine Duplikation 24 des Eingangssignals 20, so dass ein erstes und ein zweites Sollwertfilter 26, 28 mit dem identischen Eingangssignal 20 gespeist werden. Dabei ist das erste Sollwertfilter 26 in einem ersten Filterstrang 32 angeordnet und das zweite Sollwertfilter 28 in einem parallelen zweiten Filterstrang 34. Beide Sollwertfilter 26, 28 weisen jeweils eine unterschiedliche Laufzeit 19 auf. Das erste Sollwertfilter 26 erzeugt aus dem Eingangssignal 20 ein erstes Ausgangssignal 23, das an ein erstes Verzögerungsglied 30 weitergeleitet wird. Parallel dazu erzeugt das zweite Sollwertfilter 28 aus dem Eingangssignal 20 ein zweites Ausgangssignal 33, das an ein zweites Verzögerungsglied 31 weitergeleitet wird. Die Verzögerungsglieder 30, 31 weisen jeweils eine einstellbare Totzeit 25 auf und verhalten sich jeweils zum ersten und zweiten Ausgangssignal 23, 33 neutral. Das zweite Ausgangssignal 33 wird, entlang des Signallaufs 35, hinter dem zweiten Verzögerungsglied 31 über einen Signalabzweig 29 an eine Subtraktionseinheit 36 weitergeleitet. Das erste Ausgangssignal 23 wird auch nach dem ersten Verzögerungsglied 30 über einen Signalabzweig 29 an die Subtraktionseinheit 36 weitergeleitet. Die Subtraktionseinheit 36 bildet die Differenz 37 zwischen dem ersten und zweiten Ausgangssignal 23, 33 und leitet die Differenz 37 an einen Komparator 38 weiter. Der Komparator 38 ist dazu ausgebildet, zu erkennen, ob die Differenz 37 einen einstellbaren Schwellenwert unterschreitet. Ein Vorliegen einer Differenz 37, die niedriger ist als der einstellbare Schwellenwert, wird an eine Befehlseinheit 39 weitergeleitet. Die Befehlseinheit 39 ist zum Empfangen eines Umschaltbefehls 42 von einer übergeordneten Steuerung ausgebildet und gibt einen Umschaltbefehl 43 aus, wenn durch den Komparator 38 gleichzeitig eine Differenz 37 der Ausgangssignale 23, 33 unterhalb des Schwellenwerts gemeldet wird. Durch den Umschaltbefehl 43 wird ein Umschaltvorgang 48 eines Schaltmittels 46 hervorgerufen. Das Schaltmittel 46 bestimmt durch seinen Schaltzustand, welches der beiden Sollwertfilter 26, 28 mit der Ausgabeeinheit 44 verbunden ist.

In der Ausführungsform gemäß FIG 2 entspricht die Summe der Laufzeit 19 und der Totzeit 25 des zweiten Sollwertfilters 28 bzw. des Verzögerungsglieds 31 im Wesentlichen der Laufzeit 19 des ersten Sollwertfilters 26 kombiniert mit der Totzeit 25 des ersten Verzögerungsglieds 30. Infolgedessen liegen an der Subtraktionseinheit 36 stets korrespondierende, also synchrone Ausgangssignale 23, 33 an. Dadurch werden Zustände, in denen ein Umschaltvorgang 48 glatt durchführbar ist, mit minimierter Verzögerung erkannt. Dadurch können zum Umschalten der Sollwertfilter 26, 28 auch Zustände genutzt werden, die nur kurzfristig zum glatten Filterumschalten geeignet sind.

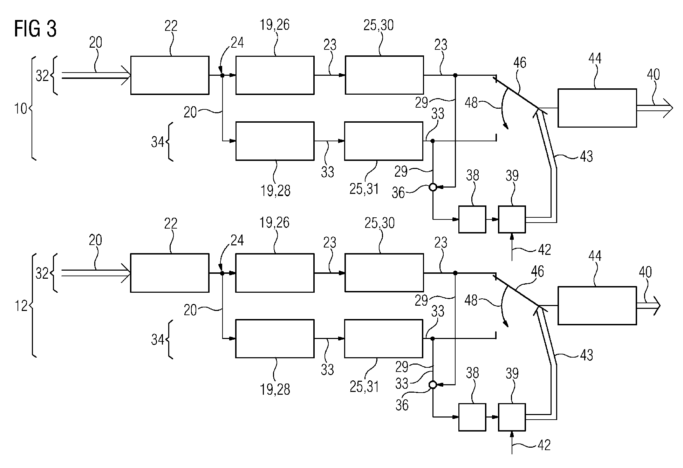

In FIG 3 ist schematisch eine dritte Ausführungsform des erfindungsgemäßen Verfahrens 100 dargestellt, in der jeweils ein Umschaltvorgang 48 von Sollwertfiltern 26, 28 für eine ersten Maschinenachse 10 und eine zweite Maschinenachse 12 durchgeführt wird. Jeweils an der ersten und der zweiten Maschinenachse 10, 12 wird ein Eingangssignal 20 zur Verfügung gestellt, dass an einer Eingangseinheit 22 ins das beanspruchte Verfahren 100 eintritt. Bezogen auf die beiden Maschinenstränge 10, 12 sind die Eingangssignale 20 voneinander unabhängig. Ausgehend von der Eingangseinheit 22 erfolgt ein Signaldurchlauf 35 in Richtung einer Ausgangseinheit 44, die ein Ausgangssignal 40 an ein nicht näher dargestelltes Antriebsmittel 52 ausgibt. Ausgehend von der Eingangseinheit 22 erfolgt eine Duplikation 24 des Eingangssignals 20, so dass ein erstes und ein zweites Sollwertfilter 26, 28 mit dem identischen Eingangssignal 20 gespeist werden. Dabei ist das erste Sollwertfilter 26 in einem ersten Filterstrang 32 angeordnet und das zweite Sollwertfilter 28 in einem parallelen zweiten Filterstrang 34. Beide Sollwertfilter 26, 28 weisen jeweils eine unterschiedliche Laufzeit 19 auf. Das erste Sollwertfilter 26 erzeugt aus dem Eingangssignal 20 ein erstes Ausgangssignal 23, das an ein erstes Verzögerungsglied 30 weitergeleitet wird. Parallel dazu erzeugt das zweite Sollwertfilter 28 aus dem Eingangssignal 20 ein zweites Ausgangssignal 33, das an ein zweites Verzögerungsglied 31 weitergeleitet wird. Die Verzögerungsglieder 30, 31 weisen jeweils eine einstellbare Totzeit 25 auf und verhalten sich jeweils zum ersten und zweiten Ausgangssignal 23, 33 neutral. Das zweite Ausgangssignal 33 wird, entlang des Signallaufs 35, hinter dem zweiten Verzögerungsglied 31 über einen Signalabzweig 29 an eine Subtraktionseinheit 36 weitergeleitet. Das erste Ausgangssignal 23 wird auch nach dem ersten Verzögerungsglied 30 über einen Signalabzweig 29 an die Subtraktionseinheit 36 weitergeleitet. Die Subtraktionseinheit 36 bildet die Differenz 37 zwischen dem ersten und zweiten Ausgangssignal 23, 33 und leitet die Differenz 37 an einen Komparator 38 weiter. Der Komparator 38 ist dazu ausgebildet, zu erkennen, ob die Differenz 37 einen einstellbaren Schwellenwert unterschreitet. Ein Vorliegen einer Differenz 37, die niedriger ist als der einstellbare Schwellenwert, wird an eine Befehlseinheit 39 weitergeleitet. Die Befehlseinheiten 39 sind jeweils zum Empfangen eines Umschaltbefehls 42 von einer übergeordneten Steuerung ausgebildet und geben jeweils einen Umschaltbefehl 43 aus, wenn jeweils durch den zugehörigen Komparator 38 gleichzeitig für jede Maschinenachse 10, 12 Differenzen 37 der Ausgangssignale 23, 33 unterhalb der jeweiligen Schwellenwerte gemeldet werden. Durch die Umschaltbefehle 43 werden separate Umschaltvorgänge 48 von Schaltmitteln 46 hervorgerufen. Jedes Schaltmittel 46 bestimmt durch seinen Schaltzustand, welches der beiden Sollwertfilter 26, 28 mit der entsprechenden Ausgabeeinheit 44 verbunden ist.

In der Ausführungsform nach FIG 3 sind die Totzeiten 25 in den Verzögerungsgliedern 30, 31 der ersten und zweiten Maschinenachse 10, 12 derart gewählt, dass die jeweils die kombinierten Laufzeiten 19 und Totzeiten 25 der Filterstränge 32, 34 in beiden Maschinenachsen 10, 12 im Wesentlichen gleich sind. Infolgedessen liegen an den Subtraktionseinheiten 36 in der ersten und zweiten Maschinenachse 10, 12 trotz unabhängiger Eingangssignale 20 stets zueinander korrespondierende, also im Wesentlichen synchrone Ausgangssignale 23, 33. Dadurch wird für beide Maschinenachsen 10, 12 gleichzeitig ein glattes Filterumschalten erzielt.

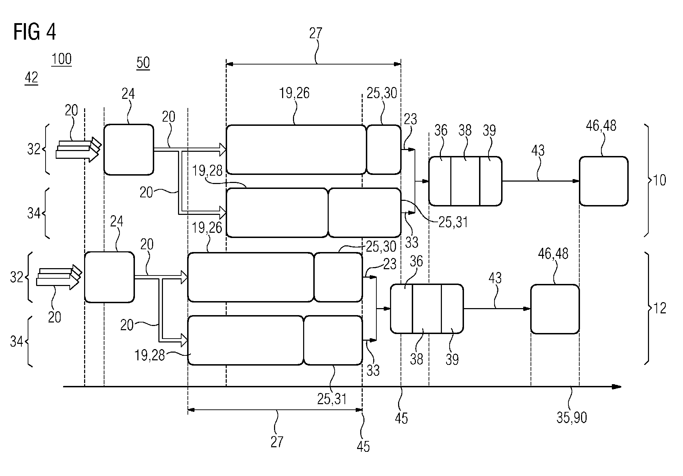

FIG 4 zeigt ein Ablaufdiagramm einer vierten Ausführungsform des erfindungsgemäßen Verfahrens 100. Das Diagramm zeigt eine Zeitachse 90, entlang der der Signaldurchlauf 35 erfolgt. Die unterbrochenen vertikalen Linien bilden dabei auf der Zeitachse 90 gleichzeitig eintretende Ereignisse ab. In FIG 4 liegt eine Steuereingabe 42 einer nicht näher dargestellten übergeordneten Steuerung vor, wonach ein Filterumschalten für zwei Maschinenachsen 10, 12 durchzuführen ist. Dabei erreichen zwei Eingangssignale 20 zu unterschiedlichen Zeitpunkten und nach einer Duplikation 24 bei jeder Maschinenachse 10, 12 in zwei separate Filterstränge 32, 34 mit jeweils einem Sollwertfilter 26, 28 geleitet. Die Eingangssignale 20 umfassen dabei Positionssollwerte, Geschwindigkeitssollwerte und Beschleunigungssollwerte, die in FIG 4 durch mehrere Pfeile angedeutet sind. Es liegen für die einzelnen Filterstränge 32, 34 der beiden Maschinenachsen 10, 12 für jeden Sollwertfilter 26, 28 unterschiedliche Laufzeiten 19 vor. Die Dauer einer Laufzeit 19 ist dabei durch die Abmessungen der den Sollwertfiltern 26, 28 zugeordneten Flächen abgebildet. Jedem der Sollwertfilter 26, 28 in den Maschinenachsen 10, 12 ist ein Verzögerungsglied 30, 31 zugeordnet, das wiederum jeweils eine eigene einstellbare Totzeit 25 aufweist. Der Signaldurchlauf 35 der Ausgangssignale 23, 33 wird in jedem Filterstrang 32, 34 um die Summe der Laufzeit 19 und der Totzeit 25 des zugehörigen Sollwertfilters 26, 28 bzw. seines Verzögerungsglieds 30, 31 verzögert. Die einstellbaren Totzeiten 25 der Verzögerungsglieder 30, 31 sind derart gewählt, dass sich für die Filterstränge 32, 34 jeweils einer Maschinenachse 10, 12 eine im Wesentlichen gleiche Gesamt-Laufzeit 27 ergibt.

Die Ausgangssignale 31, 33 werden in den Maschinenachsen 10, 12 zu unterschiedlichen Ausgabezeitpunkten 45 ihre zugeordneten Subtraktionseinheiten 36, und damit auch die jeweiligen Komparatoren 38 und Befehlseinheiten 39, weitergeleitet. Ein Zustand, der für einen Umschaltvorgang 48 geeignet ist, liegt in FIG 4 für jede einzelne Maschinenachse 10, 12 vor, so dass für beide Maschinenachsen 10, 12 ein separater Umschaltbefehl 43 zur Betätigung des Schaltmittels 46 gegeben wird. Die Umsetzung der Umschaltbehle 43 erfolgt dabei zeitlich versetzt.

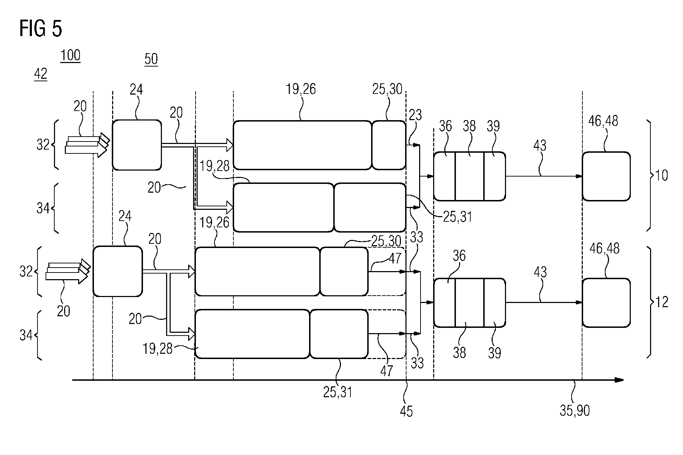

Eine weitere Ausführungsform des erfindungsgemäßen Verfahrens 100 ist in FIG 5 abgebildet. Diese zeigt ein Ablaufdiagramm einer fünften Ausführungsform des erfindungsgemäßen Verfahrens 100. Das Diagramm zeigt eine Zeitachse 90, entlang der der Signaldurchlauf 35 erfolgt. Die unterbrochenen vertikalen Linien bilden dabei auf der Zeitachse 90 gleichzeitig eintretende Ereignisse ab. In FIG 4 liegt eine Steuereingabe 42 einer nicht näher dargestellten übergeordneten Steuerung vor, wonach ein Filterumschalten für zwei Maschinenachsen 10, 12 durchzuführen ist. Dabei erreichen zwei Eingangssignale 20 zu unterschiedlichen Zeitpunkten und nach einer Duplikation 24 bei jeder Maschinenachse 10, 12 in zwei separate Filterstränge 32, 34 mit jeweils einem Sollwertfilter 26, 28 geleitet. Die Eingangssignale 20 umfassen dabei Positionssollwerte, Geschwindigkeitssollwerte und Beschleunigungssollwerte, die in FIG 4 durch mehrere Pfeile angedeutet sind. Es liegen für die einzelnen Filterstränge 32, 34 der beiden Maschinenachsen 10, 12 für jeden Sollwertfilter 26, 28 unterschiedliche Laufzeiten 19 vor. Die Dauer einer Laufzeit 19 ist dabei durch die Abmessungen der den Sollwertfiltern 26, 28 zugeordneten Flächen abgebildet. Jedem der Sollwertfilter 26, 28 in den Maschinenachsen 10, 12 ist ein Verzögerungsglied 30, 31 zugeordnet, das wiederum jeweils eine eigene einstellbare Totzeit 25 aufweist. Der Signaldurchlauf 35 der Ausgangssignale 23, 33 wird in jedem Filterstrang 32, 34 um die Summe der Laufzeit 19 und der Totzeit 25 des zugehörigen Sollwertfilters 26, 28 bzw. seines Verzögerungsglieds 30, 31 verzögert. Die einstellbaren Totzeiten 25 der Verzögerungsglieder 30, 31 sind zunächst in beiden Maschinenachsen 10, 12 derart gewählt, dass sich für die Filterstränge 32, 34 jeweils einer Maschinenachse 10, 12 eine im Wesentlichen gleiche Gesamt-Laufzeit 27 ergibt. Bei der zweiten Maschinenachse 12 wird anschließend durch eine Anpassung 47 die Dauer der Totzeiten 25 des ersten und zweiten Verzögerungsglieds 30, 31 erhöht. Die Ergänzung 47 der Totzeiten 25 ist so ausgebildet, dass die Ausgangssignale 23, 33 der ersten und zweiten Maschinenachse 10, 12 zum gleichen Ausgabezeitpunkt 45 an die jeweiligen Subtraktionseinheiten 36 weitergeleitet werden.

Die Ausgangssignale 31, 33 werden in den Maschinenachsen 10, 12 zu unterschiedlichen Ausgabezeitpunkten 45 ihre zugeordneten Subtraktionseinheiten 36, und damit auch die jeweiligen Komparatoren 38 und Befehlseinheiten 39, weitergeleitet. Ein für die Umschaltvorgänge 48 geeigneter Zustand liegt in FIG 4 für jede einzelne Maschinenachse 10, 12 vor, so dass für beide Maschinenachsen 10, 12 ein separater Umschaltbefehl 43 zur Betätigung des Schaltmittels 46 gegeben wird. Die Umsetzung der Umschaltbefehle 43, und damit die Durchführung der Umschaltvorgänge 48, erfolgt dabei zeitgleich.

## Patentansprüche

1. Filterumschaltverfahren (100) für eine Maschinensteuerung (50) mit einem ersten und einem zweiten Sollwertfilter (26, 28) während eines Betriebs eines zugehörigen Antriebsmittels (52) einer ersten Maschinenachse (32), umfassend die Schritte:
a) Anlegen eines Eingangssignals an den ersten Sollwertfilter (26) zur Erzeugung eines ersten Ausgangssignals (23), das an das Antriebsmittel (52) ausgegeben wird;
b) Anlegen des Eingangssignals (20) an den zweiten Sollwertfilter (28) zur Erzeugung eines zweiten Ausgangssignals (33) ;
c) Ermitteln einer Abweichung zwischen dem ersten und zweiten Ausgangssignal (23, 33);
d) Unmittelbares Trennen des ersten Sollwertfilters (26) vom Antriebsmittel (52) und Verbinden des zweiten Sollwertfilters (28) mit dem Antriebsmittel (52), wenn die Abweichung in Schritt c) einen einstellbaren Schwellenwert unterschreitet;
wobei das erste und zweite Sollwertfilter (26, 28) unterschiedliche Laufzeiten (19) aufweisen.

2. Filterumschaltverfahren (100) nach Anspruch 1, **dadurch gekennzeichnet, dass** zumindest der Schritt d) durchgeführt wird, wenn an der ersten Maschinenachse (32) eine Bewegung erfolgt.

3. Filterumschaltverfahren (100) nach Anspruch 1 oder 2, **dadurch gekennzeichnet, dass** mindestens eines der Ausgangssignale (23, 33) durch mindestens ein Verzögerungsglied (30, 31) mit einer einstellbaren Totzeit (25) verzögert wird.

4. Filterumschaltverfahren (100) nach Anspruch 3, **dadurch gekennzeichnet, dass** die Totzeit (25) des mindestens einen Verzögerungsglieds (30, 31) einem nicht-ganzzahligen Vielfachen einer Taktdauer (27) des Eingangssignals (20) entspricht.

5. Filterumschaltverfahren (100) nach Anspruch 3 oder 4, **dadurch gekennzeichnet, dass** die Länge der Totzeit (25) des mindestens einen Verzögerungsglieds (30, 31) der Differenz der Laufzeiten (19) des ersten und zweiten Sollwertfilters (26, 28) entspricht.

6. Filterumschaltverfahren (100) nach einem der Ansprüche 1 bis 5, **dadurch gekennzeichnet, dass** das Eingangssignal (20) einen Positionssollwert, einen Geschwindigkeitssollwert, einen Beschleunigungssollwert, und/oder einen Rucksollwert für das Antriebsmittel (52) umfasst.

7. Filterumschaltverfahren (100) nach Anspruch 6, **dadurch gekennzeichnet, dass** der im Schritt c) im ersten und zweiten Ausgangssignal (23, 33) die Abweichung der Positionssollwerte ermittelt wird.

8. Filterumschaltverfahren (100) nach Anspruch 6 oder 7, **dadurch gekennzeichnet, dass** im Schritt d) zwischen den Geschwindigkeitssollwerten, den Beschleunigungssollwerten, und/oder den Rucksollwerten in den Ausgangssignalen (23, 33) ein kontinuierlicher, insbesondere linearer, Übergang erfolgt.

9. Filterumschaltverfahren (100) nach einem der Ansprüche 1 bis 8, **dadurch gekennzeichnet, dass** die Schritte a) bis d) auch für eine zweite Maschinenachse (34) durchgeführt werden, wobei das Trennen des ersten Sollwertfilters (26) vom Antriebsmittel (52) und Verbinden des zweiten Sollwertfilters (28) mit dem Antriebsmittel bei der ersten und zweiten Maschinenachse (10, 12) im Wesentlichen gleichzeitig erfolgt.

10. Filterumschaltverfahren (100) nach Anspruch 9, **dadurch gekennzeichnet, dass** die Laufzeit (19) zumindest eines Verzögerungsglieds (31) der zweiten Maschinenachse (12) derart eingestellt wird, dass die Ausgangssignale (23, 33) im Wesentlichen synchron an die jeweiligen Subtraktionseinheiten (36) weitergeleitet werden.

11. Filterumschaltverfahren (100) nach einem der Ansprüche 1 bis 10, **dadurch gekennzeichnet, dass** mindestens eines der Sollwertfilter ein Mittelwertbilder ist.

12. Filterumschaltverfahren (100) nach einem der Ansprüche 1 bis 11, **dadurch gekennzeichnet, dass** mit einer Look-Ahead-Funktion ein Umschalt-Zeitabschnitt erkannt wird, in dem das Eingangssignal (20) zumindest einer Maschinenachse (32, 34) dazu ausgebildet ist, entlang der zumindest einen Maschinenachse (32, 34) eine Bewegung mit im Wesentlichen konstanter Geschwindigkeit hervorzurufen ->zum Umschalten geeignet.

13. Programm (80) zur Speicherung und Ausführung in einer Steuereinheit einer Maschine, das dazu ausgebildet ist, Befehle an mindestens ein Antriebsmittel der Maschine auszugeben, **dadurch gekennzeichnet, dass** das Programm (80) zur Durchführung eines Verfahrens (100) nach mindestens einem der Ansprüche 1 bis 12 ausgebildet ist.

14. Steuereinheit für eine Maschine, umfassend einen Speicher und eine Recheneinheit zur Speicherung und Ausführung eines Programms (80) nach Anspruch 13.

15. Maschine, umfassend mindestens ein Werkzeug und ein zugehöriges Antriebsmittel, **dadurch gekennzeichnet, dass** die Maschine eine Steuereinheit nach Anspruch 14 aufweist.
